# EUROPEAN PATENT APPLICATION

(11) **EP 4 167 287 A1**
(43) Date of publication of application: **19.04.2023**
(21) Application number: 22200079.6
(22) Date of filing: 06.10.2022
(51) Int. Cl.: H01L 27/146

(54) **IMAGE SENSOR AND METHOD OF FABRICATING THE SAME**

(30) Priority: 18.10.2021 KR 20210138129; 20.01.2022 KR 20220008816
(71) Applicant: Samsung Electronics Co., Ltd., Gyeonggi-do 16677 (KR)
(72) Inventor: HUR, Jaesung, 16677 Suwon-si (KR); YOON, Kjjoong, 16677 Suwon-si (KR); LIM, Hajin, 16677 Suwon-si (KR); JEON, Jongmin, 16677 Suwon-si (KR); JEON, Taeksoo, 16677 Suwon-si (KR); JOE, In Sung, 16677 Suwon-si (KR)
(74) Representative: Marks & Clerk LLP

(57) **Abstract**

An image sensor includes a substrate, a plurality of unit pixels provided on a pixel area of the substrate, a plurality of device isolation patterns defining the plurality of unit pixels on the pixel area, a light-shield layer provided on a top surface of the substrate and comprising a grid structure defining a plurality of optical transmission regions, a plurality of color filters provided on the plurality of optical transmission regions of the light-shield layer, and a plurality of micro-lenses provided on the plurality of color filters. The light-shield layer includes a light-shield pattern, a low-refractive pattern provided on the light-shield pattern, and a protection layer configured to cover the light-shield pattern and the low-refractive pattern on the substrate. The low-refractive pattern includes a porous silicon compound. Pores in the low-refractive pattern have a diameter of about 0.2 nm to about 1 nm.

## Description

### BACKGROUND

### 1. Field

Example embodiments of the present disclosure relate to an image sensor and a method of fabricating the same.

### 2. Description of Related Art

An image sensor may be a semiconductor device that transforms optical images into electrical signals. The image sensor may be classified into a charge coupled device (CCD) type and a complementary metal oxide semiconductor (CMOS) type. The CMOS image sensor (CIS) is a short name for the CMOS type image sensor. The CIS may include a plurality of two-dimensionally arranged pixels. Each of the pixels includes a photodiode (PD). The photodiode serves to transform an incident light into an electrical signal.

### SUMMARY

Provided is an image sensor that may be capable of avoiding or reducing image defects.

Additional aspects will be set forth in part in the description which follows and, in part, will be apparent from the description, or may be learned by practice of the presented embodiments.

According to an aspect of the disclosure, an image sensor may include a substrate, a plurality of unit pixels provided on a pixel area of the substrate, a plurality of device isolation patterns defining the plurality of unit pixels on the pixel area, a light-shield layer provided on a top surface of the substrate and comprising a grid structure defining a plurality of optical transmission regions, a plurality of color filters provided on the plurality of optical transmission regions of the light-shield layer, and a plurality of micro-lenses provided on the plurality of color filters. The light-shield layer may include a light-shield pattern, a low-refractive pattern provided on the light-shield pattern, and a protection layer covering the light-shield pattern and the low-refractive pattern on the substrate. The low-refractive pattern may include a porous silicon compound. Pores in the low-refractive pattern may have a diameter of about 0.2 nm to about 1 nm.

According to an aspect of the disclosure, an image sensor may include a substrate including a pixel area, a plurality of device isolation patterns defining a plurality of unit pixels on the pixel area, a plurality of photoelectric conversion regions provided in the substrate and correspondingly on the plurality of unit pixels, a plurality of impurity regions provided in the substrate and correspondingly on the plurality of unit pixels, the plurality of impurity regions being adjacent to a bottom surface of the substrate, a conductive line pattern provided in the substrate and on the bottom surface of the substrate, the conductive line pattern vertically overlapping the plurality of device isolation patterns, a light-shield layer provided on the substrate and along the plurality of device isolation patterns, the light-shield layer defining a plurality of optical transmission regions, a color filter provided on a top surface of the substrate, and a micro-lens array provided on the color filter. The light-shield layer may include a light-shield pattern, a porous low-refractive pattern provided on the light-shield pattern, and a protection layer provided on the substrate and covering the light-shield pattern and the porous low-refractive pattern. A size of pores in the porous low-refractive pattern may be less than a size of molecules of first elements included in the protection layer and a size of molecules of second elements included in the light-shield pattern. The porous low-refractive pattern may have a refractive index of about 1 to about 1.46 for a wavelength of 589 nanometers at a room temperature of 20 degrees Celsius.

According to an aspect of the disclosure, a method of fabricating an image sensor may include providing a substrate including a pixel area, forming a plurality of device isolation patterns defining a plurality of unit pixels on the pixel area, doping the plurality of unit pixels with impurities to form a plurality of photoelectric conversion regions, forming a light-shield layer on the pixel area, and forming a plurality of color filters on the pixel area. Forming the light-shield layer may include forming a light-shield film on the substrate, using a precursor to deposit a low-refractive layer on the light-shield film, the precursor including a siloxane material that includes carbon (C) and hydrogen (H), patterning the low-refractive layer and the light-shield film to form a low-refractive pattern and a light-shield pattern that are included in the light-shield layer, allowing the low-refractive pattern to undergo an oxygen (O₂) ashing process to form a plurality of pores in the low-refractive pattern, and forming on the substrate a protection layer covering the light-shield pattern and the low-refractive pattern. The plurality of pores in the low-refractive pattern may have a diameter of about 0.2 nm to about 1 nm.

According to an aspect of the disclosure, an image sensor may include a substrate, a plurality of unit pixels provided on a pixel area of the substrate, a plurality of device isolation patterns defining the plurality of unit pixels on the pixel area, a light-shield layer provided on a top surface of the substrate and including a grid structure defining a plurality of optical transmission regions, a plurality of color filters provided on the plurality of optical transmission regions of the light-shield layer, and a plurality of micro-lenses on the plurality of color filters. The light-shield layer may include a light-shield pattern, a porous low-refractive pattern provided on the light-shield pattern, and a protection layer on the substrate covering the light-shield pattern and the porous low-refractive pattern. The porous low-refractive pattern may include a compound of silicon (Si), oxygen (O), carbon (C), and hydrogen (H). In the compound, a carbon concentration and a hydrogen concentration may be less than an oxygen concentration.

At least some of the above and other features of the invention are set out in the claims.

### BRIEF DESCRIPTION OF THE DRAWINGS

The above and other aspects, features, and advantages of certain example embodiments of the present disclosure will be more apparent from the following description taken in conjunction with the accompanying drawings, in which:
FIG. 1 is a block diagram of an image sensor according to an example embodiment;
FIG. 2 is a circuit diagram of an active pixel sensor array of an image sensor according to an example embodiment;
FIG. 3 is a plan view of an image sensor according to an example embodiment;
FIG. 4 is a cross-sectional view of an image sensor according to an example embodiment;
FIG. 5 is an enlarged view of section A of FIG. 4 according to an example embodiment;
FIG. 6 is a cross-sectional view of an image sensor according to an example embodiment; and
FIGS. 7, 8, 9, 10, 11, 12, 13, 14, 15, 16, 17, 18, 19, 20, 21 and 22 are cross-sectional views of a method of fabricating an image sensor according to example embodiments.

### DETAILED DESCRIPTION

The following will now describe an image sensor according to the present disclosure with reference to the accompanying drawings.

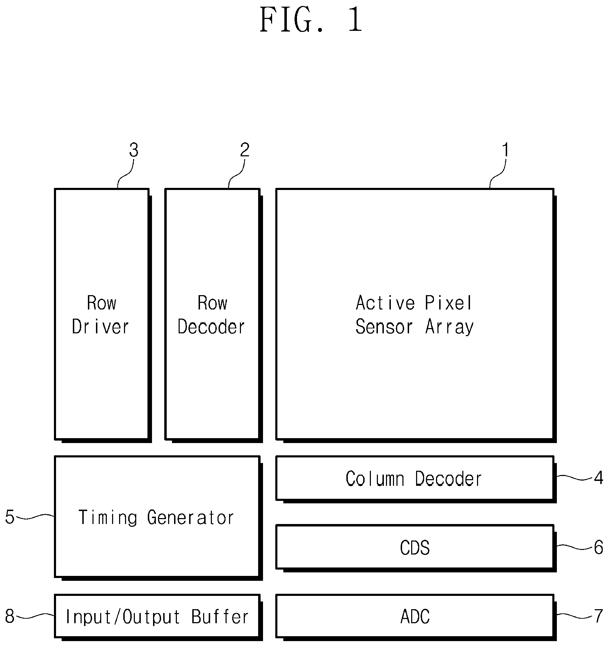

FIG. 1 illustrates a block diagram of an image sensor according to an example embodiment.

Referring to FIG. 1, an image sensor may include an active pixel sensor array 1, a row decoder 2, a row driver 3, a column decoder 4, a timing generator 5, a correlated double sampler (CDS) 6, an analog-to-digital converter (ADC) 7, and an input/output buffer 8.

The active pixel sensor array 1 may include a plurality of two-dimensionally arranged unit pixels, each of which is configured to convert optical signals into electrical signals. The active pixel sensor array 1 may be driven by a plurality of driving signals such as a pixel selection signal, a reset signal, and a charge transfer signal from the row driver 3. The correlated double sampler 6 may be provided with the converted electrical signals.

The row driver 3 may provide the active pixel sensor array 1 with several driving signals for driving several unit pixels in accordance with a decoded result obtained from the row decoder 2. When the unit pixels are arranged in a matrix shape, the driving signals may be provided to each row.

The timing generator 5 may provide timing and control signals to the row decoder 2 and the column decoder 4.

The correlated double sampler 6 may receive the electrical signals generated from the active pixel sensor array 1, and may hold and sample the received electrical signals. The correlated double sampler 6 may perform a double sampling operation to sample a specific noise level and a signal level of the electrical signal, and then may output a difference level corresponding to a difference between the noise and signal levels.

The analog-to-digital converter 7 may convert analog signals, which correspond to the difference level received from the correlated double sampler 6, into digital signals, and then output the converted digital signals.

The input/output buffer 8 may latch the digital signals and may then sequentially output the latched digital signals to an image signal processing unit in response to the decoded result obtained from the column decoder 4.

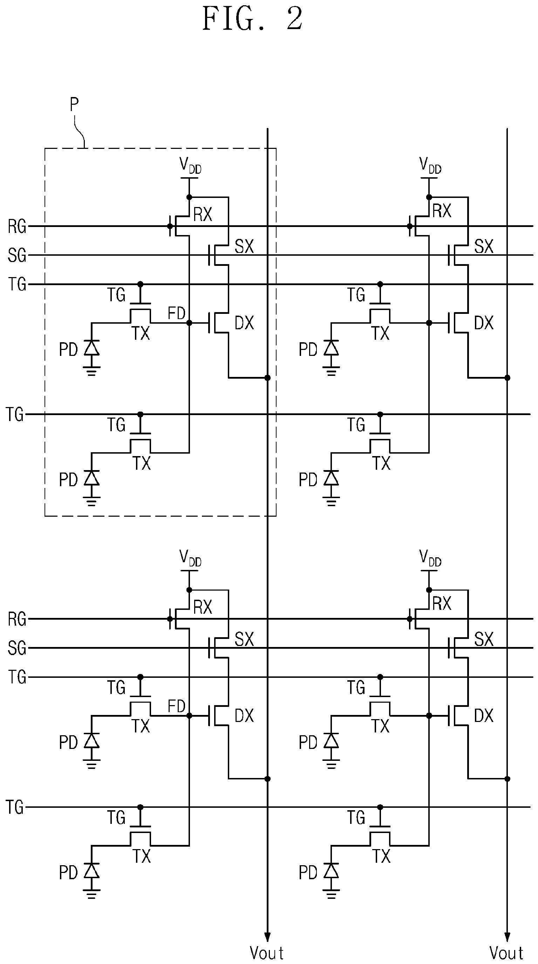

FIG. 2 is a circuit diagram of an active pixel sensor array of an image sensor according to an example embodiment.

Referring to FIGS. 1 and 2, the active pixel sensor array 1 may include a plurality of unit pixels P, which unit pixels P may be arranged in a matrix shape. Each of the unit pixels P may include at least one, but in this case two, transfer transistors TX and logic transistors RX, SX, and DX. The logic transistors RX, SX, and DX may include a reset transistor RX, a selection transistor SX, and a drive transistor DX. The transfer transistors TX may each include a transfer gate TG. Each of the unit pixels P may further include at least one photoelectric conversion element PD and a floating diffusion region FD.

The photoelectric conversion element PD may create and accumulate photo-charges in proportion to an amount of externally incident light. The photoelectric conversion element PD may include a photodiode, phototransistor, a photo-gate, a pinned photodiode, or a combination thereof. The transfer transistors TX may transfer charges generated in the photoelectric conversion elements PD into the floating diffusion region FD. The floating diffusion region FD may accumulate and store charges that are generated and transferred from the photoelectric conversion elements PD. The drive transistor DX may be controlled by an amount of photo-charges accumulated in the floating diffusion region FD.

The reset transistor RX may periodically reset the charges accumulated in the floating diffusion region FD. The reset transistor RX may have a drain electrode connected to the floating diffusion region FD and a source electrode connected to a power voltage V_{DD}. When the reset transistor RX is turned on, the floating diffusion region FD may be supplied with the power voltage V_{DD} connected to the source electrode of the reset transistor RX Accordingly, when the reset transistor RX is turned on, the charges accumulated in the floating diffusion region FD may be exhausted and thus the floating diffusion region FD may be reset. The reset transistor RX may include a reset gate RG.

The drive transistor DX may serve as a source follower buffer amplifier. The drive transistor DX may amplify a variation in electrical potential of the floating diffusion region FD and may output the amplified electrical potential to an output line V_{OUT}.

The selection transistor SX may select each row of the unit pixel P to be readout. When the selection transistor SX is turned on, the power voltage V_{DD} may be applied to a drain electrode of the drive transistor DX. The selection transistor SX may include a selection gate SG.

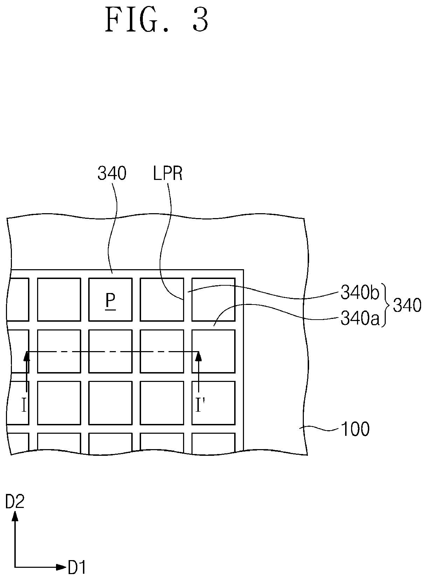

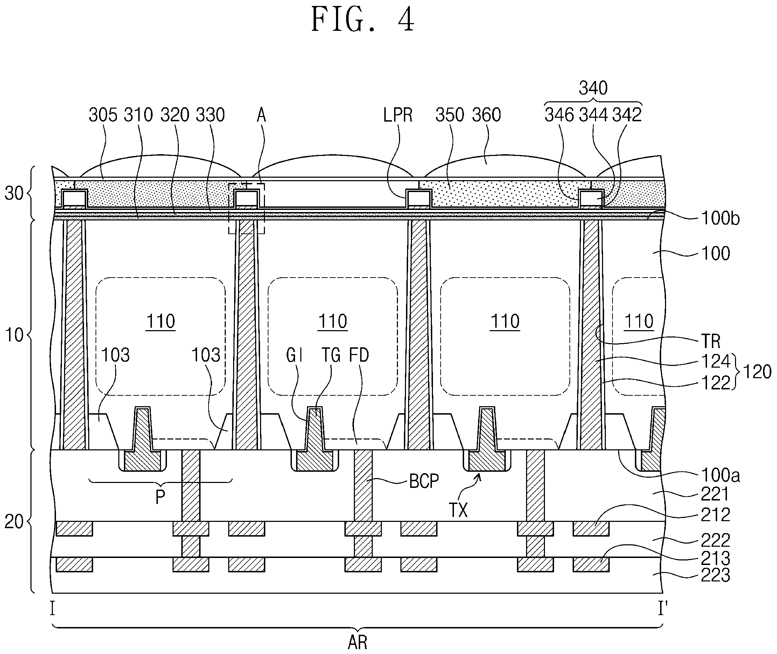

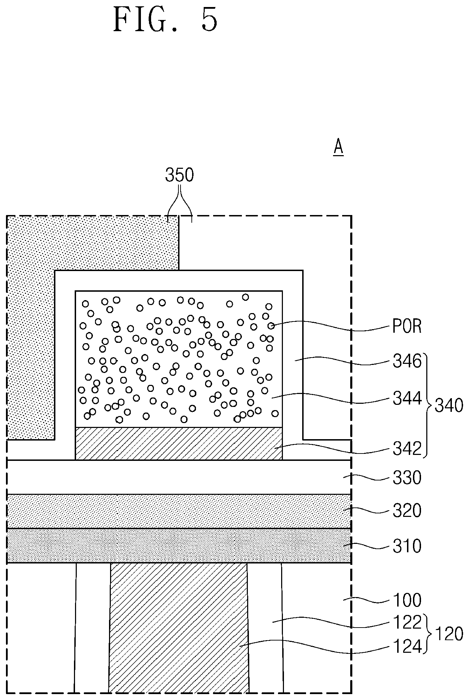

FIG. 3 is a plan view of an image sensor according to an example embodiment. FIG. 4 is a cross-sectional view taken along line I-I' of FIG. 3, of an image sensor according to an example embodiment. FIG. 5 is an enlarged view of section A of FIG. 4 according to an example embodiment.

Referring to FIGS. 3 to 5, an image sensor according to some embodiments may include a photoelectric conversion layer 10, a wiring layer 20, and an optical transmission layer 30. The photoelectric conversion layer 10 may be interposed between the wiring layer 20 and the optical transmission layer 30. The photoelectric conversion layer 10 may include a semiconductor substrate 100 and photoelectric conversion regions 110 provided in the semiconductor substrate 100.

The semiconductor substrate 100 may be a substrate in which an epitaxial layer of a first conductivity type is formed on a bulk silicon substrate of the first conductivity type. For example, the first conductivity type may be a p-type. The bulk silicon substrate may be removed in an image sensor fabrication process, such that the semiconductor substrate 100 may be formed of the epitaxial layer of the first conductivity type. Alternatively, the semiconductor substrate 100 may be a bulk silicon substrate including a well of the first conductivity type. Dissimilarly, the semiconductor substrate 100 may include an epitaxial layer of the second conductivity type, a bulk silicon substrate of the second conductivity type, or a silicon-on-insulator (SOI) substrate. For example, the second conductivity type may be an n-type. The semiconductor substrate 100 may have a first surface 100a and a second surface 100b that are opposite to each other. The wiring layer 20 may be disposed on the first surface 100a of the semiconductor substrate 100, and the optical transmission layer 30 may be disposed on the second surface 100b of the semiconductor substrate 100.

The semiconductor substrate 100 may include a pixel area AR disposed on a center of the semiconductor substrate 100 and a peripheral area that surrounds the pixel area AR. The pixel area AR may be provided thereon with a plurality of unit pixels P discussed with reference to FIG. 2. The peripheral area may be a section around the pixel area AR, which section is not provided with the unit pixels P thereon. For example, the peripheral area may be provided thereon with one or more pads through which the image sensor transmits and receives external signals. The following will describe in detail configurations of the unit pixels P.

The pixel area AR may include a plurality of unit pixels P. The unit pixels P may be two-dimensionally arranged in two directions that intersect each other when viewed in plan. For example, the unit pixels P may be arranged in a matrix shape along the two directions.

First device isolation patterns 120 may be provided adjacent to the second surface 100b of the semiconductor substrate 100, defining the plurality of unit pixels P. For example, similar to the arrangement of the unit pixels P, the first device isolation patterns 120 may be arranged along two intersecting directions. An overall shape of the first device isolation patterns 120 may have a grid structure when viewed in plan. For example, portions of the first device isolation patterns 120 may extend in a first direction D1 and may be arranged along a second direction D2 that intersects the first direction D1, and other portions of the first device isolation patterns 120 may extend in the second direction D2 and may be arranged along the first direction D1. Each of the first device isolation patterns 120 may run across between a pair of neighboring unit pixels P. A single unit pixel P may be defined to indicate a section surrounded by neighboring first device isolation patterns 120.

The first device isolation patterns 120 may be provided in a trench TR that penetrates the semiconductor substrate 100. The trench TR may have a depth substantially the same as a thickness of the semiconductor substrate 100. For example, the trench TR may vertically penetrate the semiconductor substrate 100. The trench TR may have a width that gradually increases in a direction from the second surface 100b toward the first surface 100a of the semiconductor substrate 100. Alternatively, the width of the trench TR may be uniform irrespective of distance from the second surface 100b of the semiconductor substrate 100. Dissimilarly, the trench TR may have a width that gradually decreases in a direction from the second surface 100b toward the first surface 100a of the semiconductor substrate 100. In this case, the trench TR may vertically completely penetrate the semiconductor substrate 100, or may extend from the second surface 100b of the semiconductor substrate 100 but may not reach the first surface 100a of the semiconductor substrate 100. When the trench TR does not reach the first surface 100a of the semiconductor substrate 100, an end of the trench TR may be inserted into a second device isolation pattern 103 which will be discussed below or may be spaced apart at a certain interval from the second device isolation pattern 103.

The first device isolation patterns 120 may be substantially flat on a top surface thereof. The top surfaces of the first device isolation patterns 120 may be substantially parallel to the second surface 100b of the semiconductor substrate 100. In addition, the top surfaces of the first device isolation patterns 120 may be located at the same level from the second surface 100b of the semiconductor substrate 100. For example, the top surfaces of the first device isolation patterns 120 may be positioned on one substantially flat plane. The top surfaces of the first device isolation patterns 120 may be coplanar with the second surface 100b of the semiconductor substrate 100.

Each of the first device isolation patterns 120 may include a dielectric isolation pattern 122 and a conductive isolation pattern 124.

The dielectric isolation pattern 122 may partially fill the trench TR. For example, the dielectric isolation pattern 122 may conformally cover an inner lateral surface and, optionally, a bottom surface of the trench TR. The dielectric isolation pattern 122 may include a dielectric material whose refractive index is less than that of the semiconductor substrate 100 (e.g., silicon (Si)). For example, the dielectric isolation pattern 122 may include a silicon oxide (SiO) layer, a silicon oxynitride (SiON) layer, or a silicon nitride (SiN) layer.

The conductive isolation pattern 124 may completely fill an unoccupied portion of the trench TR partially filled with the dielectric isolation pattern 122. For example, the conductive isolation pattern 124 may fill the trench TR, and in the trench TR, the dielectric isolation pattern 122 may be interposed between the conductive isolation pattern 124 and the semiconductor substrate 100. The conductive isolation pattern 124 and the dielectric isolation pattern 122 may have their top surfaces coplanar with the second surface 100b of the semiconductor substrate 100. The conductive isolation pattern 124 and the dielectric isolation pattern 122 may have their bottom surfaces coplanar with the first surface 100a of the semiconductor substrate 100. The conductive isolation pattern 124 may have a width that gradually increases in a direction from the second surface 100b toward the first surface 100a of the semiconductor substrate 100. The conductive isolation pattern 124 may include a conductive material. For example, the conductive isolation pattern 124 may include n-type doped polysilicon or p-type doped polysilicon. Alternatively, the conductive isolation pattern 124 may include metal. According to some embodiments, the conductive isolation pattern 124 may not be provided. For example, the first device isolation pattern 120 may include a dielectric isolation pattern 122 that completely fills the trench TR.

The photoelectric conversion regions 110 may be provided in corresponding unit pixels P. The photoelectric conversion region 110 may be an impurity region having the second conductivity type (e.g., n-type) different from the first conductivity type of the semiconductor substrate 100. For example, the photoelectric conversion regions 110 may be adjacent to the second surface 100b of the semiconductor substrate 100 and perpendicularly spaced apart from the first surface 100a of the semiconductor substrate 100. The photoelectric conversion regions 110 may have a difference in impurity concentration between a first section adjacent to the first surface 100a and a second section adjacent to the second surface 100b.

The photoelectric conversion regions 110 may convert externally incident light into electrical signals. For example, the semiconductor substrate 100 and the photoelectric conversion region 110 may constitute a photodiode. In each of the unit pixels P, the photodiode may be constituted by a p-n junction between the semiconductor substrate 100 of the first conductivity type and the photoelectric conversion region 110 of the second conductivity type. The photoelectric conversion regions 110 which constitute the photodiodes may generate and accumulate photo-charges in proportion to an intensity of incident light.

The semiconductor substrate 100 may be provided therein with a second device isolation pattern 103 that is adjacent to the first surface 100a and defines active patterns. Each of the unit pixels P may include the active pattern. For example, the active pattern may include a floating diffusion region FD which will be discussed below.

The second device isolation pattern 103 may have a width that gradually decreases in a direction from the first surface 100a toward the second surface 100b of the semiconductor substrate 100. The first device isolation pattern 120 may vertically penetrate the second device isolation pattern 103. The second device isolation pattern 103 may include an SiO layer, an SiON layer, or an SiN layer.

The semiconductor substrate 100 may be provided on its first surface 100a with the transfer transistors TX and the logic transistors RX, SX, and DX discussed above with reference to FIG. 2.

The transfer transistor TX may be provided on each of the unit pixels P. The transfer transistor TX may be electrically connected to the photoelectric conversion region 110. The transfer transistor TX may include a transfer gate TG and a floating diffusion region FD. The transfer gate TG may include a lower (deeper) portion inserted into the semiconductor substrate 100, and may also include an upper portion that is connected to the lower portion and protrudes onto the first surface 100a of the semiconductor substrate 100. A gate dielectric layer GI may be interposed between the transfer gate TG and the semiconductor substrate 100. The floating diffusion region FD may have the second conductivity type (e.g., n-type) opposite to the first conductivity type of the semiconductor substrate 100.

Logic transistors (see RX, SX, and DX of FIG. 2) may be provided on each of the unit pixels P. For example, the logic transistors may include a reset transistor RX.

The wiring layer 20 may include first, second, and third interlayer dielectric layers 221, 222, and 223 that cover the transfer transistors TX and the logic transistors (see RX, SX, and DX of FIG. 2), and may also include first and second conductive line patterns 212 and 213 in the second and third interlayer dielectric layers 222, and 223. The first and second conductive line patterns 212 and 213 may be electrically connected through lower contact plugs BCP in the first interlayer dielectric layer 221 to the transfer transistors TX and the logic transistors (see RX, SX, and DX of FIG. 2).

The wiring layer 20 may signally process electrical signals converted in the photoelectric conversion regions 110. The first and second conductive line patterns 212 and 213 may be respectively disposed in the second and third interlayer dielectric layers 222 and 223 stacked on the first interlayer dielectric layer 221 on the first surface 100a of the semiconductor substrate 100. In some embodiments, the first and second conductive line patterns 212 and 213 may be disposed irrespective of arrangement of the photoelectric conversion regions 110. When viewed in plan, the first and second conductive line patterns 212 and 213 may run across the photoelectric conversion regions 110.

The optical transmission layer 30 may be disposed on the second surface 100b of the semiconductor substrate 100. The optical transmission layer 30 may include a first fixed charge layer 310, a second fixed charge layer 320, a first protection layer 330, a light-shield layer 340, color filters 350, and micro-lenses 360. The optical transmission layer 30 may condense and filter externally incident light, and the photoelectric conversion layer 10 may be provided with the condensed and filtered light.

The first fixed charge layer 310 may be disposed on the second surface 100b of the semiconductor substrate 100. The second surface 100b of the semiconductor substrate 100 may be in contact with the first fixed charge layer 310. On the pixel area AR, the first fixed charge layer 310 may cover the second surface 100b of the semiconductor substrate 100. The first fixed charge layer 310 may include a single-layer or multi-layers of metal oxide or metal fluoride containing oxygen (O) or fluorine (F) whose amount is less than the stoichiometric amount. Therefore, the first fixed charge layer 310 may have a negative fixed charge. The first fixed charge layer 310 may include a single-layer or multi-layers of metal oxide or metal fluoride containing at least one metal selected from hafnium (Hf), zirconium (Zr), aluminum (Al), tantalum (Ta), titanium (Ti), yttrium (Y), and lanthanoid. For example, the first fixed charge layer 310 may include one or more of a hafnium oxide (HfO) layer and an aluminum oxide (Al₂O₃) layer. The first fixed charge layer 310 may suppress dark current and white spots.

The second fixed charge layer 320 may be stacked on the first fixed charge layer 310. On the pixel area AR, the second fixed charge layer 320 may conformally cover the first fixed charge layer 310. The second fixed charge layer 320 may include a single-layer or multi-layers of metal oxide or metal fluoride. For example, the second fixed charge layer 320 may include one or more of an HfO layer and an Al₂O₃ layer. The second fixed charge layer 320 may serve as a reinforcement layer or an adhesion layer for the first fixed charge layer 310.

The first protection layer 330 may be stacked on the second fixed charge layer 320. On the pixel area AR, the first protection layer 330 may conformally cover the second fixed charge layer 320. The first protection layer 330 may include at least one selected from plasma enhanced tetraethylorthosilicate (PE-TEOS), SiO, SiN, silicon carbonitride (SiCN), HfO, and Al₂O₃. The first protection layer 330 may serve as one or more of an anti-reflection layer and a planarization layer.

The light-shield layer 340 may be provided on the first protection layer 330. The light-shield layer 340 may be positioned on the pixel area AR of the semiconductor substrate 100. The light-shield layer 340 may have a planar shape similar to that of the first device isolation patterns 120. For example, the light-shield layer 340 may have a grid structure. For example, when viewed as illustrated in FIG. 3, the light-shield layer 340 may include first extension portions 340a that extend in the first direction D1 and second extension portions 340b that extend in the second direction D2 intersecting the first direction D1. The first extension portions 340a and the second extension portions 340b may intersect each other to define optical transmission regions LPR. The optical transmission regions LPR may be two-dimensionally arranged along the first direction D1 and the second direction D2. The optical transmission regions LPR may vertically overlap the unit pixels P. The unit pixels P may receive light through the optical transmission regions LPR. Therefore, the light-shield layer 340 may prevent crosstalk between neighboring pixels. The light-shield layer 340 may include a light-shield pattern 342, a low-refractive pattern 344, and a second protection layer 346.

The light-shield pattern 342 may be disposed on the first protection layer 330. On the pixel area AR, the light-shield pattern 342 may have a grid structure when viewed in plan. The light-shield pattern 342 may overlap the first device isolation pattern 120. For example, when viewed in plan, the light-shield pattern 342 may have a planar shape that corresponds to that of the first device isolation pattern 120. The present embodiments, however, are not limited thereto. For example, on a central portion of the pixel area AR, the light-shield pattern 342 may be vertically aligned with the first device isolation pattern 120, and on an edge region of the pixel area AR, the light-shield pattern 342 may be horizontally shifted from the first device isolation pattern 120. The light-shield pattern 342 may include a first metal. For example, the first metal may include tungsten (W), copper (Cu), Hf, Zr, Ti, Ta, Al, ruthenium (Ru), palladium (Pd), platinum (Pt), cobalt (Co), or nickel (Ni). Alternatively, the light-shield pattern 342 may include a nitride of the first metal. For example, the nitride of the first metal may include titanium nitride (TiN).

The low-refractive pattern 344 may be disposed on the light-shield pattern 342. The low-refractive pattern 344 may have a planar shape the same as that of the light-shield pattern 342. For example, the low-refractive pattern 344 may have a grid structure when viewed in plan. The low-refractive pattern 344 may have a sidewall aligned with that of the light-shield pattern 342.

As illustrated in FIG. 5, the low-refractive pattern 344 may have a refractive index less than that of the color filters 350 which will be discussed below. For example, the low-refractive pattern 344 may have a refractive index of about 1 to about 1.46. The low-refractive pattern 344 may include a porous silicon compound. For example, the silicon compound may be a compound of Si, O, carbon (C), and hydrogen (H). A carbon concentration and a hydrogen concentration in the compound may be less than an oxygen concentration in the compound. The low-refractive pattern 344 may have therein pores POR each having a size less than that of molecules of first elements (e.g., the first metal or a nitride of the first metal) included in the light-shield pattern 342 and that of molecules of second elements included in the second protection layer 346 which will be discussed below. The pores POR in the low-refractive pattern 344 may each have a diameter of about 0.2 nm to about 10 nm. For example, the pores POR in the low-refractive pattern 344 may each have a diameter of about 0.2 nm to about 1 nm.

According to some embodiments, as the low-refractive pattern 344 is made of a porous material, the low-refractive pattern 344 may have a small refractive index. For example, the pores POR of the low-refractive pattern 344 may be filled with air whose refractive index is low, and therefore the low-refractive pattern 344 may decrease in overall refractive index. In addition, as the pores POR are provided to each have a size less than that of molecules of the first elements included in the light-shield pattern 342 and that of molecules of the second elements included in the second protection layer 346, neither the first element nor the second element may diffuse into the low-refractive pattern 344. For example, neither the first element nor the second element may be introduced into the pores POR of the low-refractive pattern 344. Therefore, a dielectric constant of the low-refractive pattern 344 may be prevented from being increased due to a diffusion of materials around the low-refractive pattern 344 into the low-refractive pattern 344. Moreover, as the pores POR are dispersed in the low-refractive pattern 344, there may be total reflection of light that travels toward the low-refractive pattern 344, and there may be a reduction in light transmittance and light absorptivity of the low-refractive pattern 344. For example, the light absorptivity of the low-refractive pattern 344 may range from about 0 to about 0.1. The above-described configuration may provide the low-refractive pattern 344 with a reduced refractive index, and the light-shield pattern 342 and the low-refractive pattern 344 may promote prevention of crosstalk between pixels. Accordingly, the image sensor may have an reduction in image defects.

Referring still to FIGS 3 to 5, the second protection layer 346 may be stacked on the first protection layer 330. The second protection layer 346 may conformally cover the low-refractive pattern 344, the light-shield pattern 342, and the first protection layer 330. The second protection layer 346 may include an oxide or nitride of a second metal. The oxide or nitride of the second metal may be non-conductive. For example, the second protection layer 346 may include Al₂O₃.

Because the size of the pores POR is less than that of molecules of the first elements (e.g., the first metal or a nitride of the first metal) included in the light-shield pattern 342 and that of molecules of the second elements (e.g., an oxide of the second metal) included in the second protection layer 346, any of the first metal, a nitride of the first metal, the second metal, and an oxide of the second metal may not diffuse into the low-refractive pattern 344. For example, the low-refractive pattern 344 may contain neither the first metal nor the second metal.

The color filters 350 may be provided on the first protection layer 330 and the light-shield layer 340. The color filters 350 may be correspondingly provided on the optical transmission regions LPR of the light-shield layer 340. The color filters 350 may be disposed on corresponding unit pixels P. As illustrated in FIG. 4, the color filters 350 may cover the light-shield layer 340, and portions of the color filters 350 may fill the optical transmission regions LPR of the light-shield layer 340. Alternatively, the color filters 350 may correspondingly fill the optical transmission regions LPR of the light-shield layer 340 and may not extend onto the light-shield layer 340. Alternatively, the color filters 350 may be buried in the semiconductor substrate 100. For example, recesses, which correspond to the unit pixels P, may be formed on the second surface 100b of the semiconductor substrate 100, and the first fixed charge layer 310, the second fixed charge layer 320, and the first protection layer 330 may be formed to conformally cover insides of the recesses. In this case, on the first protection layer 330, the color filters 350 may fill the optical transmission regions LPR and the insides of the recesses. The following will describe the embodiment shown in FIG. 3. The color filters 350 may constitute a primary color filter array. For example, the color filters 350 may be formed of a combination of a green color filter, a blue color filter, and a red color filter. The color filters 350 may be arranged in one of Bayer pattern, 2 × 2 Tetra pattern, and 3 × 3 Nona pattern. For another example, the color filters 350 may include different colors such as cyan, magenta, or yellow.

The micro-lenses 360 may be correspondingly provided on the color filters 350. A planarization pattern 305 may be interposed between the color filters 350 and the micro-lenses 360.

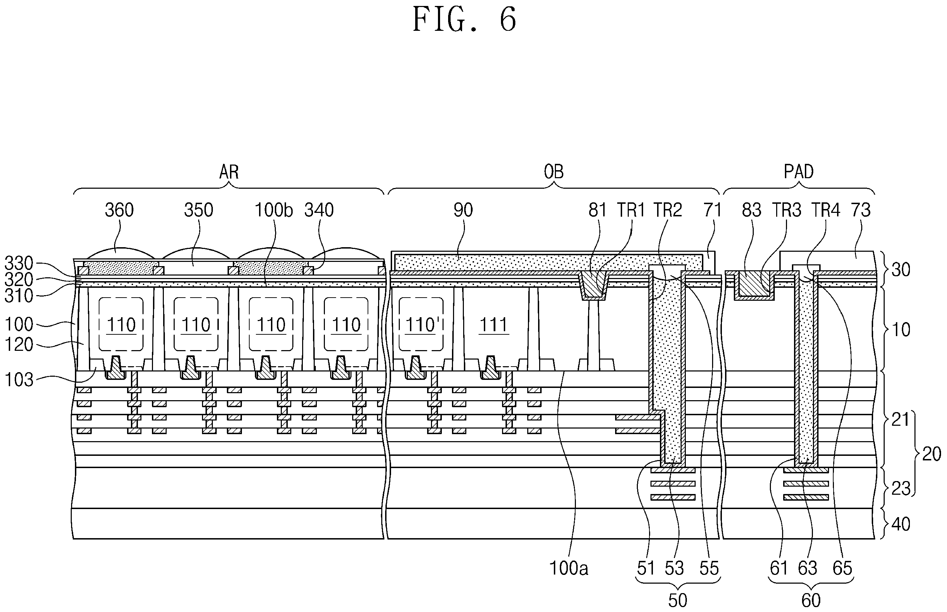

FIG. 6 is a cross-sectional view of an image sensor according to an example embodiment.

Referring to FIG. 6, an image sensor according to some embodiments may include a photoelectric conversion layer 10 including a semiconductor substrate 100 having a pixel area AR, an optical black area OB, and a pad area PAD, and may also include a wiring layer 20 on a first surface 100a of the semiconductor substrate 100 and a base substrate 40 on the wiring layer 20. The wiring layer 20 may include an upper wiring layer 21 and a lower wiring layer 23. The pixel area AR may include a plurality of unit pixels.

The pixel area AR may be substantially the same as that discussed above with reference to FIGS. 1 to 5. For example, the semiconductor substrate 100 may be provided therein with first device isolation patterns 120 by which photoelectric conversion regions 110 are separated from each other, and transistors may be provided on the first surface 100a of the semiconductor substrate 100. The semiconductor substrate 100 may be provided on its first surface 100a with the wiring layer 20 that includes conductive line patterns and also includes interlayer dielectric layers which cover transfer transistors (see TX of FIG. 2) and logic transistors (see RX, SX, and DX of FIG. 2). The semiconductor substrate 100 may be provided on its second surface 100b with an optical transmission layer 30 that includes a first fixed charge layer 310, a second fixed charge layer 320, a first protection layer 330, a light-shield layer 340, color filters 350, and micro-lenses 360. The light-shield layer 340 may be the same as that discussed with reference to FIGS. 3 to 5. For example, the light-shield layer 340 may include a light-shield pattern, a low-refractive pattern on the light-shield pattern, and a second protection layer that covers the light-shield pattern and the low-refractive pattern. The low-refractive pattern may include a porous silicon compound, and may have therein pores each having a size less than that of molecules of first elements included in the light-shield pattern and that of molecules of second elements included in the second protection layer.

On the optical black area OB, the semiconductor substrate 100 may be provided thereon with a first connection structure 50, a first conductive pad 81, and a bulk color filter 90. The first connection structure 50 may include a first light-shield pattern 51, a dielectric pattern 53, and a first capping pattern 55.

The first light-shield pattern 51 may be provided on the second surface 100b of the semiconductor substrate 100. For example, the first light-shield pattern 51 may cover the first protection layer 330 on the second surface 100b, and may conformally cover an inner wall of each of first and second trenches TR1 and TR2. The first light-shield pattern 51 may penetrate the photoelectric conversion layer 10 and the upper wiring layer 21, and may connect the photoelectric conversion layer 10 to the wiring layer 20. For example, the first light-shield pattern 51 may be in contact with wiring lines in the upper and lower wiring layers 21 and 23 and with a first device isolation pattern 120 in the photoelectric conversion layer 10. Therefore, the first connection structure 50 may be electrically connected to the wiring lines in the wiring layer 20. The first light-shield pattern 51 may include a metallic material (e.g., W). The first light-shield pattern 51 may block incidence of light onto the optical black area OB.

The first conductive pad 81 may be provided in the first trench TR1 and may fill an unoccupied portion of the first trench TR1. The first conductive pad 81 may include a metallic material (e.g., Al). The first conductive pad 81 may be connected to the conductive isolation pattern 124 of FIG. 4. A negative bias voltage may be applied through the first conductive pad 81 to the conductive isolation pattern 124. Therefore, it may be possible to prevent or reduce white spot and/or dark current.

The dielectric pattern 53 may fill an unoccupied portion of the second trench TR2. The dielectric pattern 53 may penetrate the photoelectric conversion layer 10 and all or a portion of the wiring layer 20. The first capping pattern 55 may be provided on a top surface of the dielectric pattern 53. The first capping pattern 55 may be provided on a portion of the first light-shield pattern 51.

The bulk color filter 90 may be provided on the first conductive pad 81, the first light-shield pattern 51, and the first capping pattern 55. The bulk color filter 90 may cover the first conductive pad 81, the first light-shield pattern 51, and the first capping pattern 55. A third protection layer 71 may be provided on and cover the bulk color filter 90.

A photoelectric conversion region 110' and a dummy region 111 may be provided on the optical black area OB of the semiconductor substrate 100. The photoelectric conversion region 110' may be doped with impurities of the second conductivity type different from the first conductivity type. For example, the second conductivity type may be an n-type. The photoelectric conversion region 110' on the optical black area OB may have a structure similar to that of the photoelectric conversion region 110 on the pixel area AR, and may not perform an operation (e.g., generation of electrical signals from received light) the same as that of the photoelectric conversion region 110 on the pixel area AR. The dummy region 111 may not be doped with impurities. The dummy region 111 may generate signals that are used as information to eliminate subsequent process noise.

On the pad area PAD, the semiconductor substrate 100 may be provided thereon with a second connection structure 60 a second conductive pad 83, and a fourth protection layer 73. The second connection structure 60 may include a second light-shield pattern 61, a dielectric pattern 63, and a second capping pattern 65.

The second light-shield pattern 61 may be provided on the second surface 100b of the semiconductor substrate 100. For example, the second light-shield pattern 61 may cover the first protection layer 330 on the second surface 100b, and may conformally cover an inner wall of each of third and fourth trenches TR3 and TR4. The second light-shield pattern 61 may penetrate the photoelectric conversion layer 10 and the upper wiring layer 21, and may connect the photoelectric conversion layer 10 to the wiring layer 20. For example, the second light-shield pattern 61 may be in contact with wiring lines in the lower wiring layer 23. Therefore, the second connection structure 60 may be electrically connected to the wiring lines in the wiring layer 20. For example, the second light-shield pattern 61 may include a metallic material (e.g., W).

A second conductive pad 83 may be provided in the third trench TR3, and may fill an unoccupied portion of the third trench TR3. The second conductive pad 83 may include a metallic material (e.g., Al). The second conductive pad 83 may serve as an electrical connection path through which the image sensor device is connected to an external apparatus. The dielectric pattern 63 may fill an unoccupied portion of the fourth trench TR4. The dielectric pattern 63 may penetrate the photoelectric conversion layer 10 and all or a portion of the wiring layer 20. The second capping pattern 65 may be provided on the dielectric pattern 63. The fourth protection layer 73 may cover the second capping pattern 65 and a portion of the second light-shield pattern 61.

A current applied via the second conductive pad 83 may flow to the first device isolation patterns 120 through the second light-shield pattern 61, the wiring lines in the wiring layer 20, and the first light-shield pattern 51. The photoelectric conversion regions 110 and 110' and the dummy region 111 may generate electrical signals, and the electrical signals may be outwardly transmitted through the wiring lines in the wiring layer 20, the second light-shield pattern 61, and the second conductive pad 83.

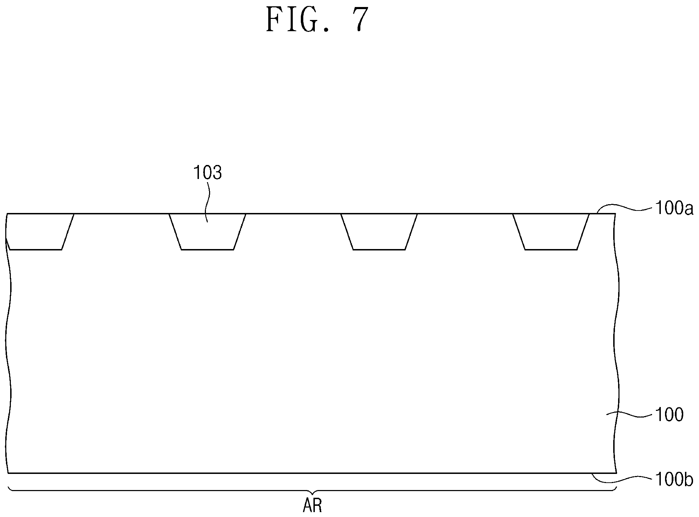

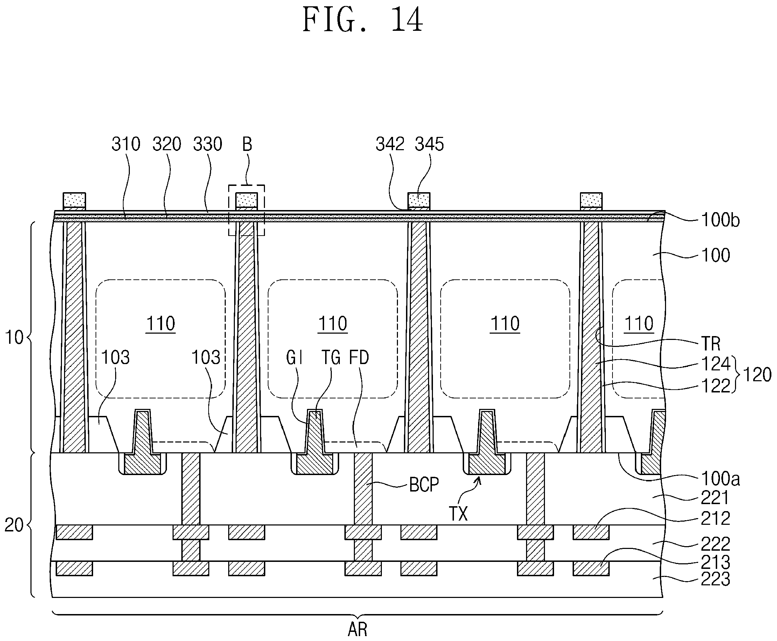

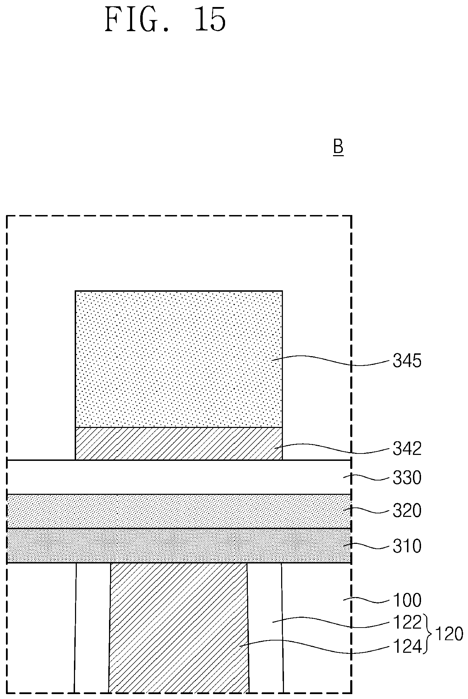

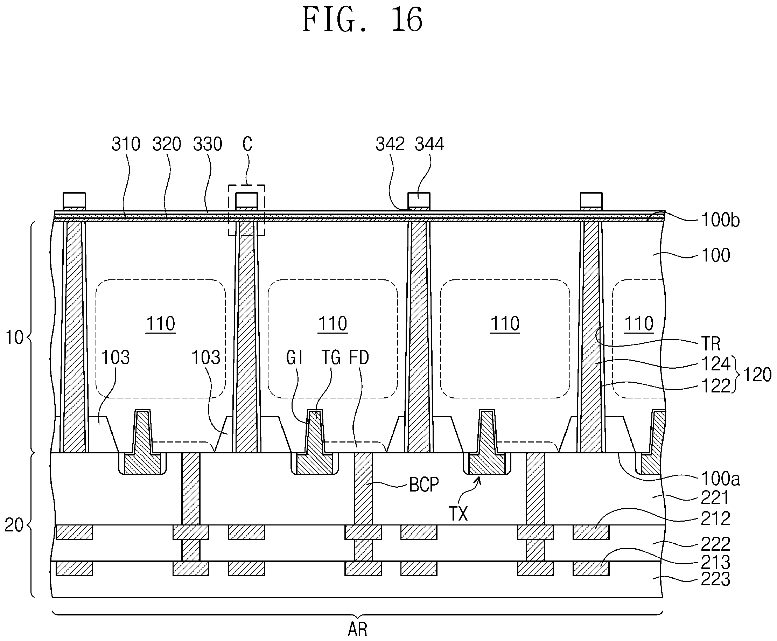

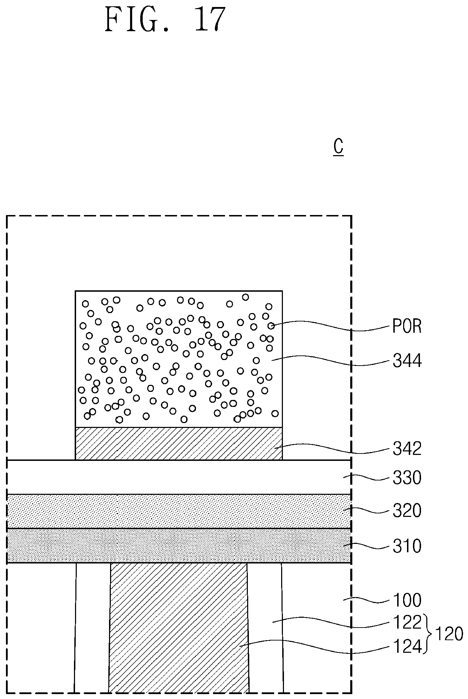

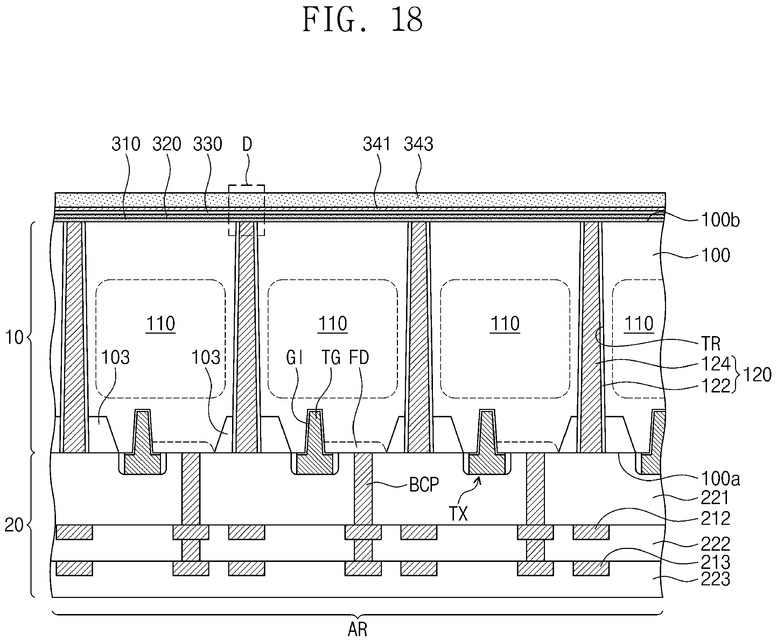

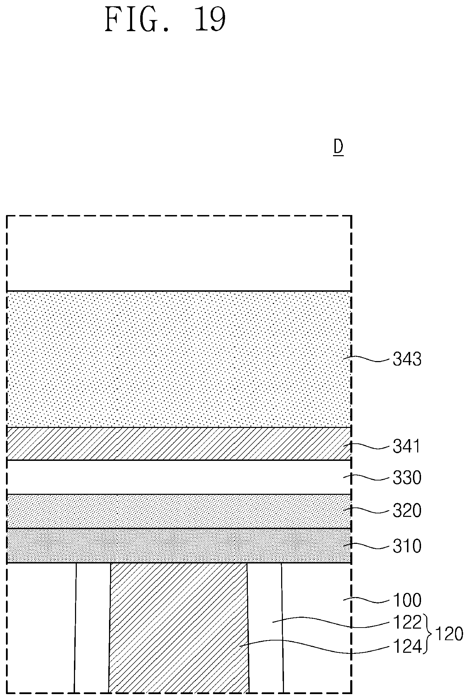

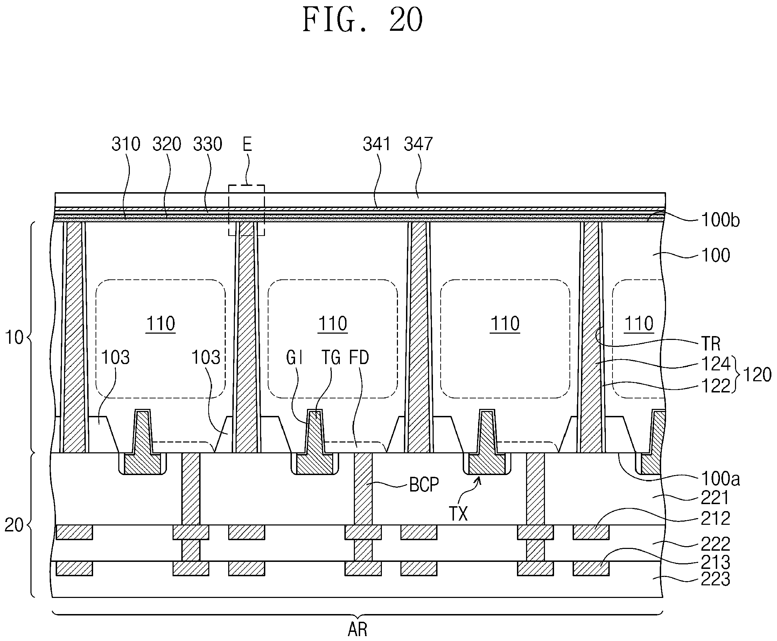

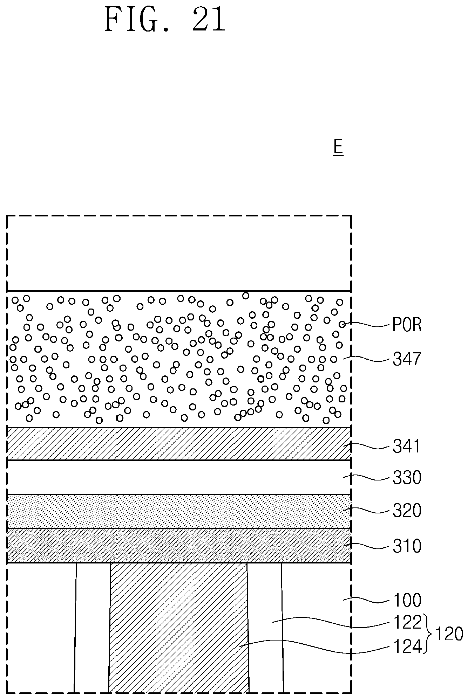

FIGS. 7, 8, 9, 10, 11, 12, 13, 14, 15, 16, 17, 18, 19, 20, 21 and 22 are cross-sectional views of a method of fabricating an image sensor according to example embodiments. FIGS. 7 to 14, 16, 18, 20, and 22 are cross-sectional views of a method of fabricating an image sensor according to some embodiments. FIG. 15 is an enlarged view of section B of FIG. 14. FIG. 17 is an enlarged view of section C of FIG. 16. FIG. 19 is an enlarged view of section D of FIG. 18. FIG. 21 is an enlarged view of section E of FIG. 20.

Referring to FIG. 7, a semiconductor substrate 100 may be provided to have a first surface 100a and a second surface 100b that are opposite to each other. The semiconductor substrate 100 may include a pixel area AR disposed on a center thereof and a peripheral area that surrounds the pixel area AR

A second device isolation pattern 103 may be formed on the first surface 100a of the semiconductor substrate 100. The second device isolation pattern 103 may define active patterns.

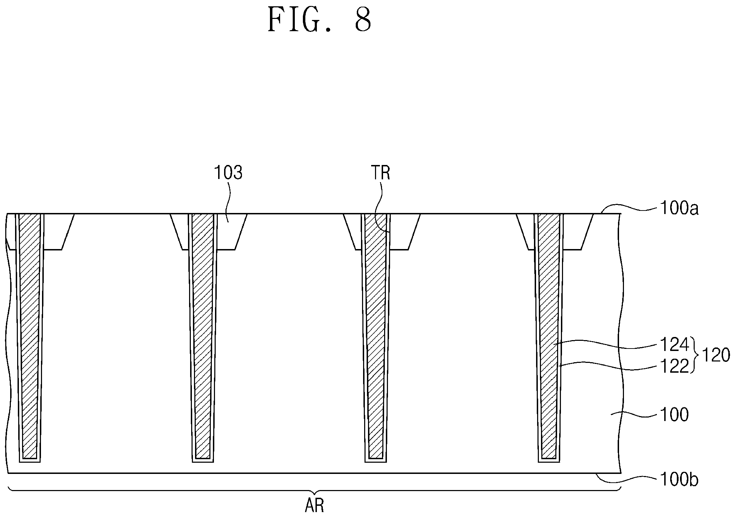

Referring to FIG. 8, the first surface 100a of the semiconductor substrate 100 may undergo an etching process to form a trench TR through the second device isolation pattern 103. The trench TR may have a width that gradually decreases in a direction from the first surface 100a toward the second surface 100b of the semiconductor substrate 100. When viewed in plan, the trench TR may be formed to have a grid structure. The trench TR may define a plurality of unit pixels on the pixel area AR.

First device isolation patterns 120 may be formed to fill the trench TR. The first device isolation patterns 120 may each include a dielectric isolation pattern 122 and a conductive isolation pattern 124. The formation of the dielectric isolation pattern 122 and the conductive isolation pattern 124 may include conformally forming a dielectric layer that partially fills the trench TR, forming on the dielectric layer a conductive layer that fills the trench TR, and performing a planarization process on the dielectric layer and the conductive layer until the first surface 100a of the semiconductor substrate 100 is exposed. For example, the dielectric isolation pattern 122 may include an SiO layer, an SiON layer, or an SiN layer. The conductive isolation pattern 124 may include n-type doped polysilicon or p-type doped polysilicon.

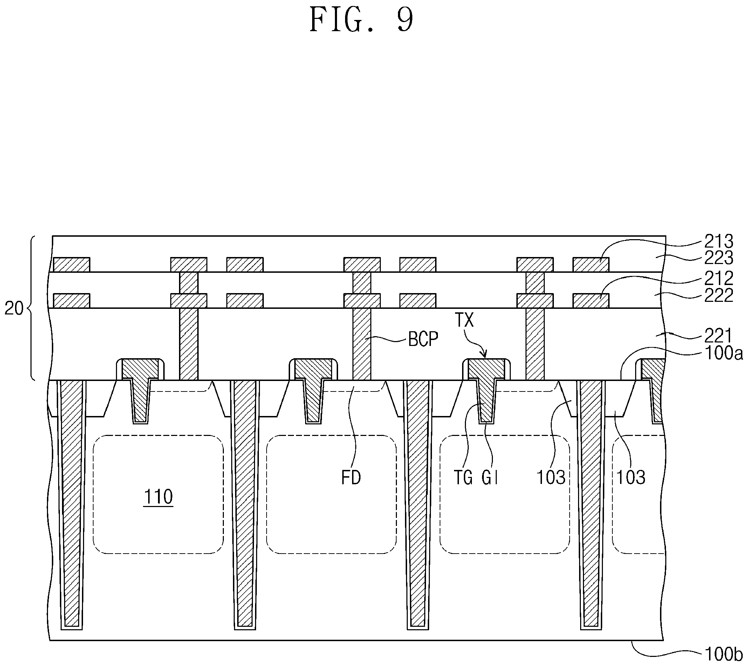

Referring to FIG. 9, the active patterns may be doped with impurities to form floating diffusion regions FD and impurity regions. The transfer transistors TX and the logic transistors RX, SX, and DX discussed above with reference to FIG. 2 may be formed on the active patterns.

A wiring layer 20 may be formed on the semiconductor substrate 100. First, second, and third interlayer dielectric layers 221, 222, and 223 may be formed on the first surface 100a of the semiconductor substrate 100. First and second conductive line patterns 212 and 213 may be respectively formed in the second and third interlayer dielectric layers 222 and 223, and lower contact plugs BCP may be formed in the first interlayer dielectric layer 221 to connect the floating diffusion regions FD to the first and second conductive line patterns 212 and 213.

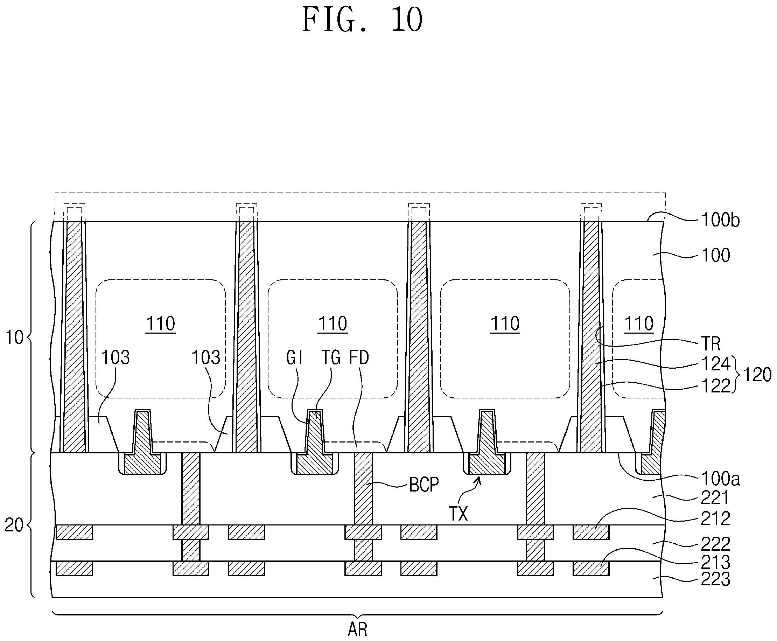

Referring to FIG. 10, the second surface 100b of the semiconductor substrate 100 may undergo a first planarization process to expose the first device isolation patterns 120. The first planarization process may include a chemical mechanical polishing (CMP) process. The first planarization process may remove a portion of the semiconductor substrate 100, and may expose top surfaces of the first device isolation patterns 120. In this step, the dielectric isolation pattern 122 of the first device isolation pattern 120 may have an exposed top surface, and the conductive isolation pattern 124 of the first device isolation pattern 120 may have an exposed top surface.

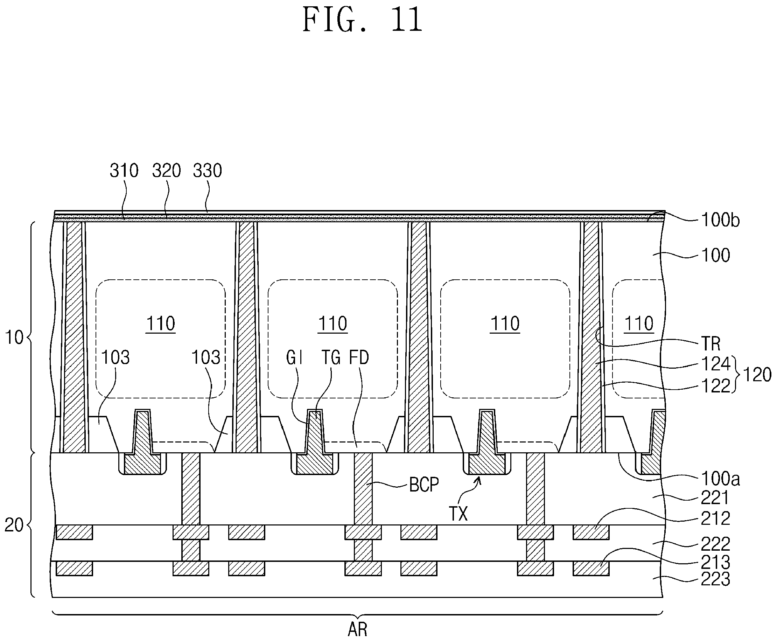

Referring to FIG. 11, a first fixed charge layer 310 may be conformally formed on the second surface 100b of the semiconductor substrate 100. A second fixed charge layer 320 may be conformally formed on the first fixed charge layer 310. A first protection layer 330 may be conformally formed on the second fixed charge layer 320. On the pixel area AR, the first device isolation patterns 120 may be covered with the first fixed charge layer 310, the second fixed charge layer 320, and the first protection layer 330. The first fixed charge layer 310 may be formed of metal oxide or metal fluoride containing at least one metal selected from Hf, Zr, Al, Ta, Ti, Y, and lanthanoid. The second fixed charge layer 320 may be formed using a single-layer or multi-layers of metal oxide or metal fluoride. The first protection layer 330 may be formed of at least one selected from plasma enhanced PE-TEOS, SiO, SiN, SiCN, HfO, and Al₂O₃.

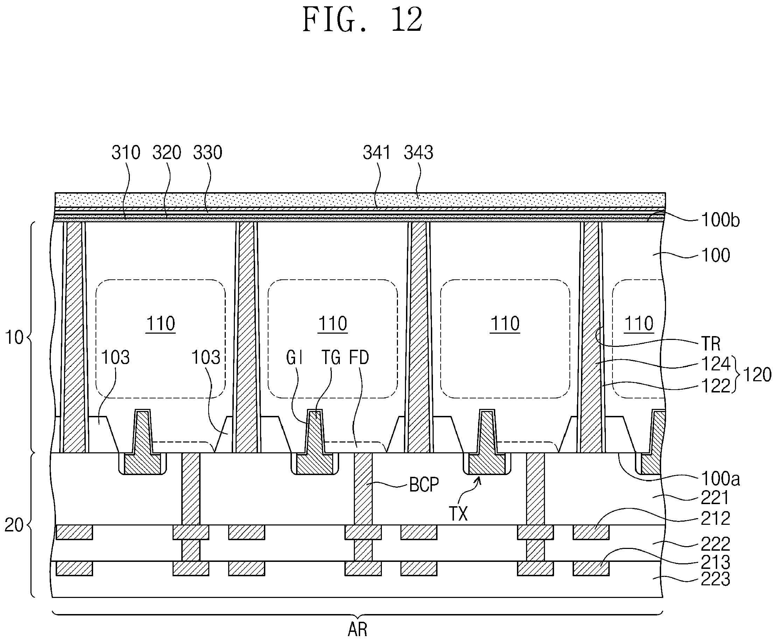

Referring to FIG. 12, on the pixel area AR, a light-shield film 341 may be formed on the first protection layer 330. The light-shield film 341 may include a first metal. For example, the first metal may include W, Cu, Hf, Zr, Ti, Ta, Al, Ru, Pd, Pt, Co, or Ni. Alternatively, the light-shield film 341 may include a nitride of the first metal. For example, the nitride of the first metal may include TiN.

Afterwards, a low-refractive material may be deposited on the light-shield film 341 to form a low-refractive layer 343. The formation of the low-refractive layer 343 may include performing a plasma-enhanced chemical vapor deposition (PECVD) process. The low-refractive material may include a silicon compound. For example, the silicon compound may be a compound of Si, O, C and H.

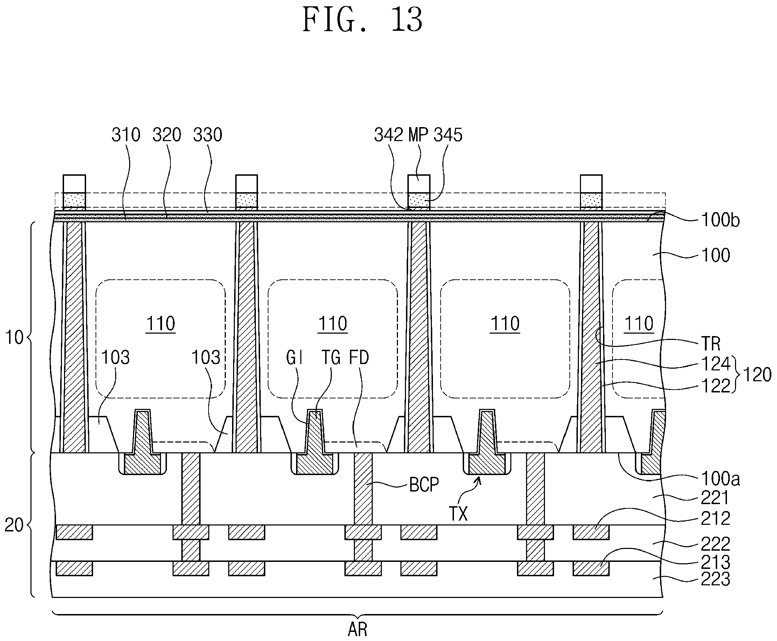

Referring to FIG. 13, the low-refractive layer 343 and the light-shield film 341 may be patterned to form a preliminary low-refractive pattern 345 and a light-shield pattern 342. For example, a mask pattern MP may be formed on the low-refractive layer 343, and then the mask pattern MP may be used as a mask to perform an etching process to etch the low-refractive layer 343 and the light-shield film 341. The mask pattern MP may have a planar shape similar to that of the first device isolation patterns 120. For example, the mask pattern MP may have a grid structure. Therefore, the preliminary low-refractive pattern 345 and the light-shield pattern 342 may each have a grid structure, and optical transmission regions may be defined between inner sides of the preliminary low-refractive pattern 345 and the light-shield pattern 342 that are formed by etching the low-refractive layer 343 and the light-shield film 341.

Referring to FIGS. 14 and 15, the mask pattern MP may be removed.

The preliminary low-refractive pattern 345 may include a silicon compound. For example, the silicon compound may be a compound of Si, O, C and H. The O, C and H may have the same or similar concentrations in the silicon compound. In addition, the preliminary low-refractive pattern 345 may have no pores therein.

Referring to FIGS. 16 and 17, the preliminary low-refractive pattern 345 may undergo an ashing process to form a porous low-refractive pattern 344. For example, the ashing process may include an oxide (O₂) ashing process. As the preliminary low-refractive pattern 345 is formed of a compound of Si, O, C and H, carbon atoms and hydrogen atoms may be discharged from the preliminary low-refractive pattern 345 in the ashing process. For example, in the ashing process, carbon and hydrogen in the preliminary low-refractive pattern 345 may combine with each other to discharge from the preliminary low-refractive pattern 345. Therefore, after the ashing process, the preliminary low-refractive pattern 345 may have a reduced carbon concentration and a reduced hydrogen concentration, and in the preliminary low-refractive pattern 345, the carbon concentration and the hydrogen concentration may be less than an oxygen concentration. The preliminary low-refractive pattern 345 may include pores POR that are formed at locations from which carbon and hydrogen are discharged. Accordingly, the porous low-refractive pattern 344 may be formed.

The pores POR in the low-refractive pattern 344 may have each have a size less than that of molecules of first elements (e.g., the first metal or a nitride of the first metal) included in the light-shield pattern 342 and that of molecules of second elements included in a second protection layer 346 which will be discussed below. The pores POR in the low-refractive pattern 344 may each have a diameter of about 0.2 nm to about 10 nm. For example, the pores POR in the low-refractive pattern 344 may each have a diameter of about 0.2 nm to about 1 nm.

FIGS. 14 to 17 depict that the low-refractive layer 343 is patterned to from the preliminary low-refractive pattern 345 and then an ashing process is performed to form the low-refractive pattern 344, but the disclosure are not limited thereto.

Referring to FIGS. 18 and 19, as discussed in FIG. 12, a light-shield film 341 and a low-refractive layer 343 may be sequentially formed on the first protection layer 330 on the pixel area AR. The light-shield film 341 may include a first metal or a nitride of the first metal. Afterwards, a low-refractive material may be deposited on the light-shield film 341 to form a low-refractive layer 343. The formation of the low-refractive layer 343 may include performing a PECVD process. The low-refractive material may include a silicon compound. For example, the silicon compound may be a compound of Si, O, C and H. The O, C and H may have the same or similar concentrations in the silicon compound. In addition, the low-refractive layer 343 may have no pores therein.

Referring to FIGS. 20 and 21, the low-refractive layer 343 may undergo an ashing process to form a porous low-refractive layer 347. For example, the ashing process may include an O₂ ashing process. As the low-refractive layer 343 is formed of a compound of Si, O, C and H, carbon atoms and hydrogen atoms may be discharged from the low-refractive layer 343 in the ashing process. For example, in the ashing process, carbon and oxygen in the low-refractive layer 343 may combine with each other to discharge from the low-refractive layer 343. Therefore, after the ashing process, the low-refractive layer 343 may have a reduced carbon concentration and a reduced hydrogen concentration, and in the low-refractive layer 343, the carbon concentration and the hydrogen concentration may be less an oxygen concentration. The low-refractive layer 343 may have pores POR that are formed at locations from which carbon and hydrogen are discharged. Accordingly, the porous low-refractive layer 347 may be formed.

Thereafter, the porous low-refractive layer 347 and the light-shield film 341 may be patterned to form a low-refractive pattern 344 and a light-shield pattern 342. The low-refractive pattern 344 and the light-shield pattern 342 may each have a grid structure, and optical transmission regions may be defined between inner sides of the low-refractive pattern 344 and the light-shield pattern 342 that are formed by etching the porous low-refractive layer 347 and the light-shield film 341. The following description will focus on the embodiment of FIGS. 14 to 17.

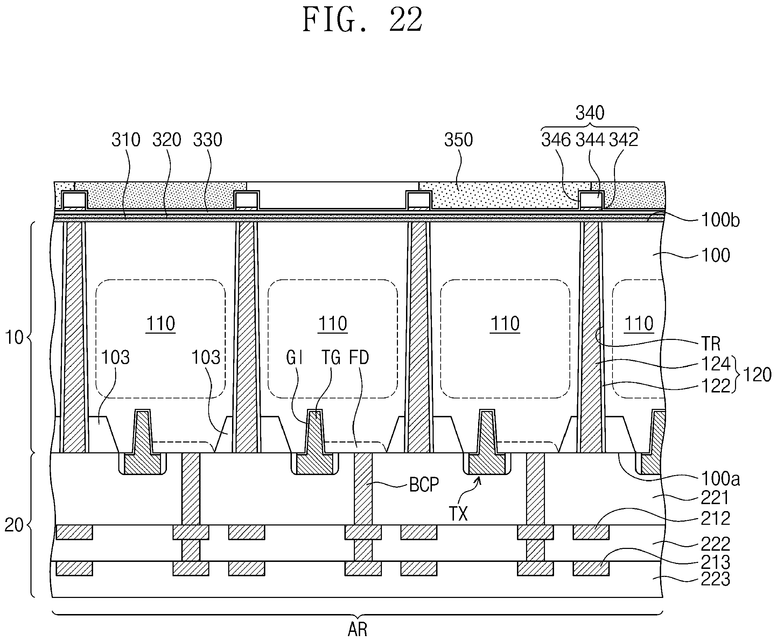

Referring to FIG. 22, a second protection layer 346 may be conformally formed on the second surface 100b of the semiconductor substrate 100. The second protection layer 346 may include a non-conductive oxide or nitride of a second metal. For example, the second protection layer 346 may include Al₂O₃. The light-shield pattern 342, the low-refractive pattern 344, and the second protection layer 346 may constitute a light-shield layer 340.

According to some embodiments, as the pores POR are provided to each have a size less than that of molecules of the first elements included in the light-shield pattern 342 and that of molecules of the second elements included in the second protection layer 346, neither the first element nor the second element may diffuse into the low-refractive pattern 344. For example, even at the time of heating due to a deposition process for forming the second protection layer 346, a subsequent process including an annealing process, and/or an operation of the image sensor, neither the first element nor the second element may diffuse into the low-refractive pattern 344.

After forming the second protection layer 346, color filters 350 may be formed on the second protection layer 346. A photolithography process may be performed several times to form the color filters 350 on the semiconductor substrate 100. For example, a first photolithography process may be performed to form first color filters at the same time. A first photosensitive thermosetting resin solution containing a blue dye may be coated on the second surface 100b of the semiconductor substrate 100. The first photosensitive thermosetting resin solution may be heated and cured to form a first photoresist layer. Exposure and development processes may be performed to form the first color filters. Subsequently, second and third photolithography processes identical or similar to the first photolithography process may be sequentially performed to respectively form second and third color filters.

Referring back to FIG. 4, a planarization pattern 305 may be formed on the semiconductor substrate 100. The planarization pattern 305 may have a substantially flat top surface.

Afterwards, micro-lenses 360 may be formed on the planarization pattern 305.

An image sensor according to some embodiments may include a low-refractive pattern formed of a porous material by which the low-refractive pattern has a low refractive index. In addition, pores may be provided to have their sizes each of which is less than that of molecules of elements included in a light-shield pattern and that of molecules of elements included in a protection layer, and thus any of the elements may not diffuse into the low-refractive pattern. Accordingly, a dielectric constant of the low-refractive pattern may be prevented from being increased due to a diffusion of materials around the low-refractive pattern into the low-refractive pattern. The above-described configuration may provide the low-refractive pattern with a low refractive index, and the light-shield pattern and the low-refractive pattern may promote prevention of crosstalk between pixels. Accordingly, the image sensor may have a reduction of image defects.

At least one of the components, elements, modules or units (collectively "components" in this paragraph) represented by a block in the drawings such as FIG. 1 may be embodied as various numbers of hardware, software and/or firmware structures that execute respective functions described above. At least one of these components may use a direct circuit structure, such as a memory, a processor, a logic circuit, a look-up table, etc. that may execute the respective functions through controls of one or more microprocessors or other control apparatuses. Also, at least one of these components may be specifically embodied by a module, a program, or a part of code, which contains one or more executable instructions for performing specified logic functions, and executed by one or more microprocessors or other control apparatuses. Further, at least one of these components may include or may be implemented by a processor such as a central processing unit (CPU) that performs the respective functions, a microprocessor, or the like. Two or more of these components may be combined into one single component which performs all operations or functions of the combined two or more components. Also, at least part of functions of at least one of these components may be performed by another of these components. Functional aspects of the above example embodiments may be implemented in algorithms that execute on one or more processors. Furthermore, the components represented by a block or processing steps may employ any number of related art techniques for electronics configuration, signal processing and/or control, data processing and the like.

Although the disclosure been described in connection with some embodiments illustrated in the accompanying drawings, it will be understood by one of ordinary skill in the art that variations in form and detail may be made therein without departing from the essential features of the disclosure. The above disclosed embodiments should thus be considered illustrative and not restrictive.

## Claims

1. An image sensor comprising:
a substrate;
a plurality of unit pixels provided on a pixel area of the substrate;
a plurality of device isolation patterns defining the plurality of unit pixels on the pixel area;
a light-shield layer provided on a top surface of the substrate, the light-shield layer comprising a grid structure defining a plurality of optical transmission regions;
a plurality of color filters provided on the plurality of optical transmission regions of the light-shield layer; and
a plurality of micro-lenses provided on the plurality of color filters,
wherein the light-shield layer comprises:
a light-shield pattern;
a low-refractive pattern provided on the light-shield pattern; and
a protection layer that covers the light-shield pattern and the low-refractive pattern on the substrate,
wherein the low-refractive pattern comprises a porous silicon compound, and
wherein each of pores in the low-refractive pattern has a diameter of about 0.2 nm to about 1 nm.

2. The image sensor of claim 1, wherein a size of each of the pores is less than a size of molecules of first elements included in the light-shield pattern and a size of molecules of second elements included in the protection layer.

3. The image sensor of claim 1 or 2, wherein the low-refractive pattern has a refractive index of about 1 to about 1.46.

4. The image sensor of any preceding claim, wherein the low-refractive pattern has a light absorptivity of about 0 to about 0.1.

5. The image sensor of any preceding claim, wherein the low-refractive pattern comprises a compound of silicon (Si), oxygen (O), carbon (C), and hydrogen (H), and
wherein, in the compound, a carbon concentration and a hydrogen concentration are less than an oxygen concentration.

6. The image sensor of any preceding claim, wherein the protection layer comprises an oxide of a second metal, and
wherein the low-refractive pattern does not contain the second metal.

7. The image sensor of any preceding claim, wherein the light-shield pattern comprises a first metal or a nitride of the first metal, and
wherein the low-refractive pattern does not contain the first metal.

8. An image sensor of any preceding claim comprising:
a plurality of photoelectric conversion regions provided in the substrate and correspondingly on the plurality of unit pixels;
a plurality of impurity regions provided in the substrate and correspondingly on the plurality of unit pixels, the plurality of impurity regions being adjacent to a bottom surface of the substrate; and
a conductive line pattern provided in the substrate and on the bottom surface of the substrate, the conductive line pattern vertically overlapping the plurality of device isolation patterns.

9. A method of fabricating an image sensor, the method comprising:
providing a substrate comprising a pixel area;
forming a plurality of device isolation patterns defining a plurality of unit pixels on the pixel area;
doping the plurality of unit pixels with impurities to form a plurality of photoelectric conversion regions;
forming a light-shield layer on the pixel area; and
forming a plurality of color filters on the pixel area,
wherein forming the light-shield layer comprises:
forming a light-shield film on the substrate;
using a precursor to deposit a low-refractive layer on the light-shield film, the precursor comprising a siloxane material that comprises carbon (C) and hydrogen (H);
patterning the low-refractive layer and the light-shield film to form a low-refractive pattern and a light-shield pattern that are included in the light-shield layer;
subjecting the low-refractive pattern to an oxygen (O₂) ashing process to form a plurality of pores in the low-refractive pattern; and
forming on the substrate a protection layer that covers the light-shield pattern and the low-refractive pattern, and
wherein the plurality of pores in the low-refractive pattern have a diameter of about 0.2 nm to about 1 nm.

10. The method of claim 9, wherein, in the oxygen ashing process, carbon and hydrogen in the low-refractive pattern are partially discharged.

11. The method of claim 9 or 10, wherein a size of each of the plurality of pores is less than a size of molecules of first elements included in the light-shield pattern and a size of molecules of second elements included in the protection layer.

12. The method of any of claims 9 to 11, wherein the light-shield film comprises a first metal,
wherein the protection layer comprises an oxide of a second metal, and
when the low-refractive pattern is formed, and when the protection layer is formed, neither the first metal of the light-shield film nor the second metal of the protection layer diffuses into the low-refractive pattern.
